# EUROPÄISCHE PATENTANMELDUNG

(11) **EP 0 899 776 A1**
(43) Veröffentlichungstag der Anmeldung: **03.03.1999**
(21) Anmeldenummer: 97114683.2
(22) Anmeldetag: 25.08.1997
(51) Int. Cl.: H01L 21/00

(54) **Vorrichtung zur Zwischenlagerung von Wafern**

(71) Anmelder: Stäubli AG Pfäffikon, 8808 Pfäffikon (CH)
(72) Erfinder: Balg, Christian, 8272 Ermatingen (CH); Strasser, Bernhard, 8274 Tägerwilen (CH); Blattner, Jakob, 8272 Ermatingen (CH)
(74) Vertreter: EGLI-EUROPEAN PATENT ATTORNEYS

(57) **Zusammenfassung**

Für den Austausch von mit Wafern bestückten Pods (5) mit einer Wafer-Bearbeitungsanlage (1) werden erfindungsgemäss die manuell oder automatisch zugeführten Pods (5) von einem Entnahmebereich (4;4',4'') mittels einer Austauschvorrichtung (3) entweder zwischengelagert oder direkt einer Transferstation (2) zur Uebergabe an die Bearbeitungsanlage (1) zugeführt. In der Austauschvorrichtung (3) werden die Pods (5) mittels Schwenkarmen (6) resp. Greifarm (10) auf Lagerplätze (8), Austauschplätze (7,7') oder Transferplätze (9,9') positioniert. Damit wird der Austausch der Pods (5) vom Bearbeitungszyklus getrennt, womit die Bearbeitungsanlage (1) optimal betrieben werden kann, ohne durch den Austauschablauf beeinflusst zu werden.

## Beschreibung

Die vorliegende Erfindung betrifft ein Verfahren nach dem Oberbegriff von Anspruch 1 sowie eine Vorrichtung nach dem Oberbegriff von Anspruch 5.

Die Beschickung von Wafer-Bearbeitungsanlagen mit Wafern erfolgt herkömmlicherweise unter Verwendung von Wafer-Magazinen in Form von genormten verschliessbaren Boxen. Diese Boxen werden nachfolgend als Pods bezeichnet. Die verschlossenen Pods müssen einer Transfervorrichtung zugeführt werden, in welcher sie unter Einhaltung von Reinraumbedingungen geöffnet werden und die Wafer der Bearbeitungsanlage zugeführt werden. Nach der Bearbeitung der Wafer werden diese in die Haltevorrichtung resp. Magazin des Pods zurücktransportiert und der Pod wird geschlossen. Anschliessend können die Pods der Transfervorrichtung entnommen und weitertransportiert werden.

Die Pods werden der Transfervorrichtung herkömmlicherweise häufig manuell zu- resp. weggeführt, d.h. der Bearbeitungsprozess ist von diesem manuellen Eingriff abhängig. Es müssen somit in durch den Bearbeitungszyklus vorgegebenen Abständen Pods ausgetauscht werden, was einerseits zu unproduktiven Wartezeiten für die Bedienung führt und andererseits bei verspätetem Austausch den Bearbeitungsprozess unterbricht.

Die Aufgabe der vorliegenden Erfindung bestand nun darin, eine Beschickungseinrichtung für Wafer-Bearbeitungsanlagen zu finden, welche diese Nachteile überwindet.

Diese Aufgabe wird durch das erfindungsgemässe Verfahren mit den kennzeichnenden Merkmalen nach Anspruch 1 gelöst.

Bevorzugte Ausführungsformen der Erfindung ergeben sich aus den weiteren abhängigen Ansprüchen 2 bis 4.

Durch das erfindungsgemäss vorgeschlagene Verfahren wird die Abhängigkeit des Austausches der Pods mit dem Bearbeitungsverfahren aufgehoben, indem ggf. eine Zwischenlagerung der Pods vorgesehen ist. Damit ist es möglich, die auszutauschenden Pods direkt mit der Bearbeitungsvorrichtung auszutauschen oder aber durch Zwischenlagerung den Bearbeitungsvorgang zu einer vom Austauschzeitpunkt unabhängigen Zeitpunkt durchzuführen. Das Zwischenlager dient somit als eine Art Puffer. Durch diese Unabhängigkeit können beispielsweise auch grössere Bearbeitungsmengen zeitlich zu bestimmten Zeiten vorgeplant und dann automatisch durchgeführt werden, d.h. die dafür vorgesehenen Pods werden dem Zwischenspeicher zu einem beliebigen Zeitpunkt vor dem Bearbeitungszeitpunkt zugeführt und verbleiben dort, bis die Bearbeitung stattfinden soll; beispielsweise während der Nacht oder nach der Vornahme einer länger dauernden Einstellungsänderung an der Bearbeitungsvorrichtung selbst. Vorteilhafterweise können nun die Pods auch nach der Bearbeitung vor der Entnahme wieder zwischengespeichert werden. Damit wird ein Unterbruch der Bearbeitung durch Blockierung durch nicht weggeführte Pods vermieden.

Erfindungsgemäss wird für die Durchführung dieses Verfahrens eine Vorrichtung mit den Merkmalen nach Anspruch 5 vorgeschlagen. Weitere bevorzugte Ausführungsformen der Vorrichtung ergeben sich aus den abhängigen Ansprüchen 6 bis 9. Die bevorzugte erfindungsgemässe kreisförmige Anordnung der Lagerplätze in mehreren übereinanderliegenden Ebenen führt vorteilhafterweise zu kurzen Transportwegen und damit zu kurzen Transportzeiten innerhalb der Vorrichtung bei geringem Platzbedarf. Damit kann auch eine einfach Anpassung des Speicher- resp. Lagervolumens an die Bedürfnisse erreicht werden, indem das Volumen einfach durch Aufstocken der Anzahl Lagerplätze in die Höhe, d.h. durch Hinzufügen von weiteren Lagerebenen erhöht werden kann, ohne Veränderung oder Anpassung der wichtigen Schnittstellenbereiche, der Transfer- und Austauschplätze.

Es versteht sich von selbst, dass der Betrieb dieser Vorrichtung vorzugsweise mittels einer den Bedürfnissen und Anforderungen angepassten computergestützten Steuerung erfolgt.

Ein Ausführungsbeispiel der vorliegenden Erfindung wird nachstehend anhand der Figuren der beiliegenden Zeichnung noch näher erläutert. Es zeigen
Fig. 1 schematisch die Aufsicht auf eine erfindungsgemässe Vorrichtung, angeflanscht an eine Wafer-Bearbeitungsanlage;
Fig. 2 schematisch die Seitenansicht der Anordnung nach Figur 1;
Fig. 3 den Schnitt durch eine erfindungsgemässe Vorrichtung in Aufsicht;
Fig. 4 den Längsschnitt durch die Vorrichtung nach Figur 3;
Figur 5 einen weiteren Längsschnitt durch die Vorrichtung nach Figur 3; und
Figur 6 eine Aufsicht wie Figur 3 mit geänderter Anordnung des Eingabe- / Entnahmebereiches.

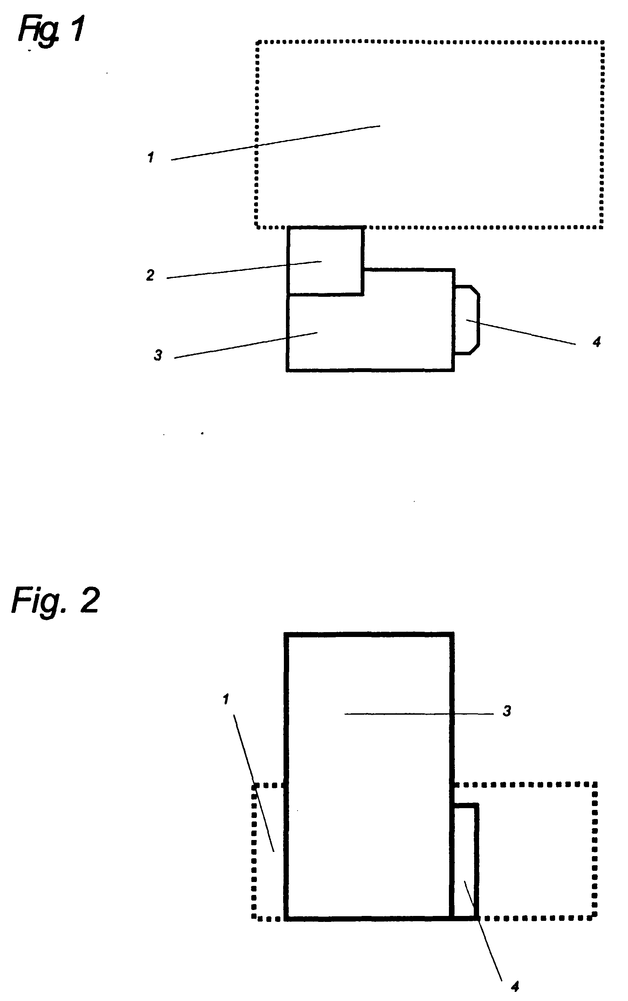

Figur 1 zeigt schematisch die Aufsicht auf eine Anordnung mit einer Wafer-Bearbeitungsanlage 1, einer daran angeflanschten Transferstation 2 und einer an diese angeflanschten erfindungsgemässen Austauschvorrichtung 3 mit Eingabe- resp. Entnahmebereich 4. Figur 2 zeigt dieselbe Anordnung schematisch in der Frontansicht.

Herkömmlicherweise wird die Transferstation 2 direkt beschickt, und zwar hauptsächlich manuell. D.h. dass eine Bedienperson die Pods mit den darin gelagerten Wafern einem Eingabebereich der Transferstation 2 manuell zuführt, worauf der Pod anschliessend automatisch innerhalb der Transferstation verschoben, geöffnet und die Wafer daraus entnommen und der Bearbeitungsanlage 1 zugeführt werden. Dies muss unter Reinraumbedingungen erfolgen, weshalb eine Reihe von Lösungen bekannt sind, wie die Pods vom normalen Aussenraum über Schleusen in den Reinraum transportiert und erst unter Reinraumbedingungen geöffnet werden. Nach der Bearbeitung der Wafer werden diese wieder in die Pods verfrachtet, diese wieder geschlossen und dem Entnahmebereich der Transferstation 2 zugeführt. Hier müssen nun die Pods wieder entnommen und weitertransportiert werden. Wenn nun die Bedienperson hierfür nicht anwesend ist, wird der ganze Bearbeitungsprozess verzögert, da die Transferstation dadurch blockiert bleibt. Dies kann nur dadurch gelöst werden, dass die Bedienperson praktisch während des gesamten Bearbeitungsprozesses neben der Maschine unproduktiv warten muss, um diesen Moment nicht zu verpassen. Für hohe Durchsatzraten bei kurzen Bearbeitungszeiten ist dieses Vorgehen überhaupt nicht mehr geeignet. Hierfür wird nun vorgeschlagen, die Pods mit den Wafern nicht direkt der Transferstation zuzuführen, sondern einer vorgeschalteten erfindungsgemässen Austauschvorrichtung 3. Diese kann wie herkömmlich bekannt manuell bedient werden, d.h. manuell be- resp. entladen werden, oder auch automatisch mit einem Förderprozess. Vorteilhafterweise wird durch diese Austauschvorrichtung 3, welche einen Zwischenlagerbereich aufweist, der Prozess der Transferstation 2 und der Be- und Entladeprozess voneinander getrennt, d.h. im wesentlichen unabhängig voneinander betrieben.

Durch diese Trennung der beiden Prozesse kann nun der eigentliche Bearbeitungsprozess auch dann fortgesetzt werden, wenn ein Pod mit den gerade bearbeiteten Wafern nicht sofort aus der Anlage entladen wird. Er wird dann einfach zwischengelagert, bis er entnommen werden kann. Andererseits kann die Anlage auch mit zu bearbeitenden Pods beladen werden, wenn momentan die Bearbeitungsanlage stillsteht. Vorteilhafterweise kann damit auch geplant ein Batch-Betrieb stattfinden, bei welchem die Bearbeitung der Wafer zu einem ganz bestimmten Zeitpunkt stattfinden soll, die Pods aber bereits früher bereitgestellt worden sind und ggf. auch erst nach Ablauf der gesamten Bearbeitungszeit entnommen werden können.

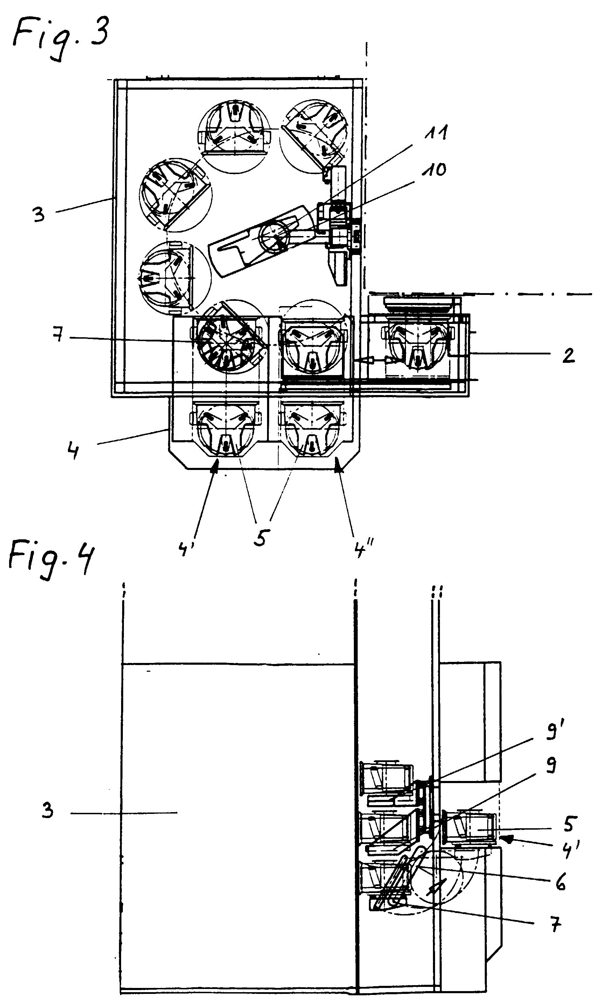

In Figur 3 ist nun der Querschnitt durch eine erfindungsgemäss ausgestaltete Austauschvorrichtung 3 dargestellt. Der Entnahmebereich 4 weist hier beispielsweise zwei nebeneinanderliegende Aufnahmestellen 4', 4'' für die zu be- resp. entladenden Pods 5 auf. Von diesen Positionen 4' resp. 4'' werden die Pods mittels eines Schwenkarmes 6, wie in Figur 4 im Seitenschnitt dargestellt, auf einen Austauschplatz 7 resp. 7' innerhalb der Austauschvorrichtung 3 verschwenkt. Von dieser Position 7,7' aus kann nun ein Pod 5 entweder auf einen Lagerplatz 8 der Austauschvorrichtung 3 transportiert werden oder direkt auf einen Transferplatz 9, von wo aus der Pod 5 der Transferstation 2 zugeführt wird, resp. von dieser herkommend abgestellt wird. Der Transport erfolgt erfindungsgemäss mit einem Greifarm 10, welcher um seine Hochachse 11 drehbar gelagert in der Austauschvorrichtung 3 angeordnet ist und entlang der Hochachse 11 in der Höhe verfahrbar ist. Die Greifmittel des Greifarmes 10 selbst sind entlang der Greifarmachse radial zur Hochachse 11 bewegbar. Durch diese Anordnung des Greifarmes 10 lassen sich die Pods 5 auf radial um die Hochachse 11 angeordnete Lagerplätze 8 einer Lagerplatzebene abstellen. Vorteilhafterweise können nun praktisch eine beliebige Anzahl von Lagerplatzebenen im Gehäuse der Austauschvorrichtung 3 übereinander angeordnet werden, praktisch nur eingeschränkt durch die maximal zur Verfügung stehenden Bauhöhe der gesamten Anlage. Ebenfalls lässt sich eine derartige, bestehende Anlage leicht erweitern, indem lediglich in der Höhe der Raum für zusätzliche Lagerplätze 8 erweitert wird, und die Höhenverstellung des Greifarmes 10 verlängert wird. Davon sind aber insbesondere die Aufnahmestellen und die Austausch- 7,7' resp. Transferplätze 9,9' nicht betroffen, und damit die aufwendigen und komplexen Bereiche der Austauschvorrichtung 3.

Die Ansteuerung des Antriebs des Greifarmes 10 kann nun beispielsweise derart computerunterstützt erfolgen, dass jeder neu auf einen Lagerplatz 8 abzustellende Pod 5 auf einen den Transferplätzen 9,9' nächstliegenden freien Lagerplatz 8 transportiert wird, resp. jeder von der Transferstation 2 herkommende verarbeitete Pod 5 einem den Austauschplätzen 7,7' nächstliegenden freien Lagerplatz 8 zugeführt wird. Damit werden vorteilhafterweise die Wege und damit auch die Transferzeiten klein gehalten. Es ist beispielsweise auch denkbar, dass wenn sowohl die Transferplätze 9,9' wie auch die Austauschplätze 7,7' besetzt sind, aufgrund eines Belegungsplanes der Lagerplätze 8 entfernt abgestellte Pods auf nähere, freie Lagerplätze 8 umgeladen werden, beispielsweise unter Berücksichtigung der Verarbeitungsreihenfolge der verschiedenen Pods 5. Der Belegungsplan kann durch an den Lagerplätzen 8 vorgesehenen Belegungssensoren laufend aufdatiert werden.

Vorzugsweise sind die Aufnahmeelemente der Austauschplätze 7,7' drehbar ausgelegt, damit die dorthin verschwenkten Pods 5 in dieselbe Winkellage bezüglich der Greifachse des Greifarmes 10 verdreht werden können wie diejenigen auf den Transferplätze 9,9' befindlichen Pods 5. Damit müssen die Greifmittel des Greifarmes 10 lediglich eine Haltebewegung und eine lineare, radial zur Hochachse 11 gerichtete Translationsbewegung durchführen. Dies vereinfacht wesentlich den Aufbau dieses Greifarmes im Vergleich zu einem Mehrachs-Greifmittel.

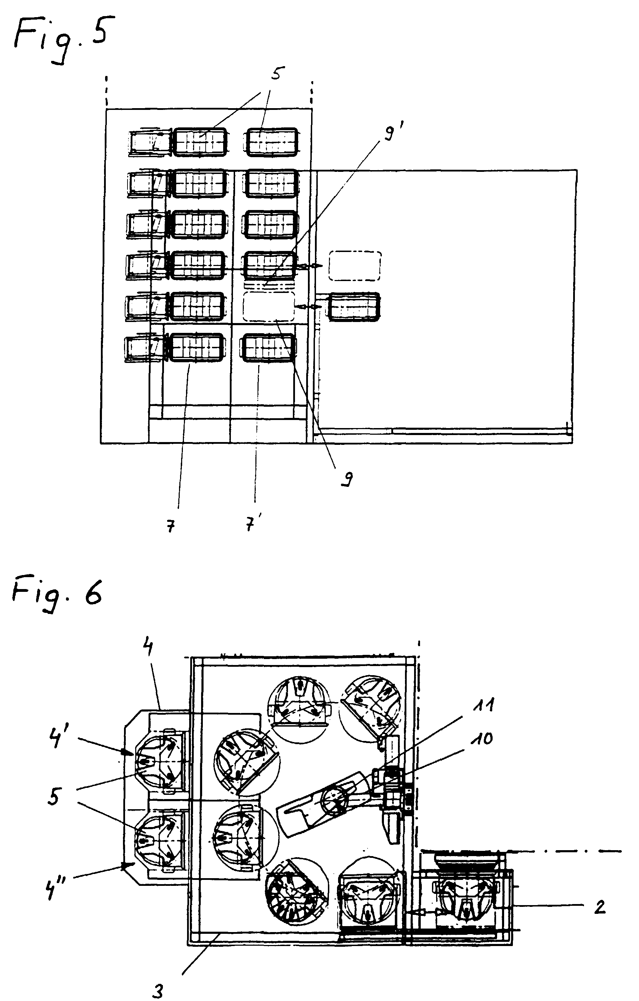

In Figur 5 ist noch eine weiterer Seitenschnitt durch die erfindungsgemässe Umladevorrichtung 3 dargestellt, aus welcher die Anordnung mehrerer Lagerebenen für die Pods 5 klar hervorgeht. Mittels Pfeilen ist auch der Transferweg der auf den Transferplätzen 9,9' abgestellten resp. abzustellenden Pods 5 dargestellt. Besonders deutlich geht hier die Anordnung von zwei übereinanderliegenden Transferplätzen 9,9' hervor, resp. die Anordnung von zwei benachbarten Austauschplätzen 7 resp. 7'.

Ein Vorteil des erfindungsgemäss ausgebildeten Vorrichtung besteht nun weiter darin, dass der Entnahmebereich 4 praktisch beliebig an einer Seitenwand der Austauschvorrichtung 3 angeordnet werden kann, wie in Figur 6 dargestellt ist. Hier ist im Vergleich mit Figur 3 der Entnahmebereich 4 von der vorderen Gehäuseseite auf die linke Gehäuseseite verschoben worden. D.h. dass insbesondere die Aufnahmestellen 4' resp. 4'' mit ihren zugehörigen Schwenkarmen 6 an dieser Position angeordnet worden sind und damit auch die Austauschplätze 7 resp. 7'. Dies kann dank der erfindungsgemässen Aufbauweise selbst bei einer bestehenden Vorrichtung nachträglich vorgenommen werden, ohne dass ein grosser oder insbesondere teurer Umbauaufwand entsteht.

## Patentansprüche

1. Verfahren zum Austausch von Wafer-Pods (5) mit einer Fertigungsvorrichtung für Wafer (1), wobei die Pods (5) manuell oder automatisch zu- resp. weggeführt werden, dadurch gekennzeichnet, dass für die Zuführung eines neuen Pods (5) mit zu bearbeitenden Wafern in einem Eingabebereich (4) mittels Sensoren jeweils die Anwesenheit eines neuen Pods (5) erfasst wird und danach bei positiver Erfassung der Pod (5) auf einen Austauschplatz (7,7') eines Zwischenlagerregals verschwenkt wird, und dass unabhängig davon eine Transportvorrichtung (10) Pods (5) von den besetzten Lagerplätzen (8) des Zwischenregals resp. des Austauschplatzes (7,7') einem Transferplatz (9,9') zur direkten Weiterleitung an die Transferstation (3) der Fertigungsvorrichtung (1) oder einem anderen, freien Lagerplatz (8) zuführt resp. von der Transferstation (2) kommende Pods (5) vom Transferplatz (9,9') zu einem freien Lagerplatz (8) resp. einem freien Austauschplatz (7,7') wegführt, und dass unabhängig davon ein auf einem Austauschplatz (7,7') befindlicher Pod (5) mit bearbeiteten Wafern zum Eingabebereich (4) hin verschwenkt wird.

2. Verfahren nach Anspruch 1, dadurch gekennzeichnet, dass die Transportvorrichtung (10) derart angesteuert wird, dass die Pods (5) jeweils auf den nächsten freien Lagerplatz (8) mit dem kürzesten Transportweg zum Transferplatz (9,9') resp. Austauschplatz (7,7') transportiert werden.

3. Verfahren nach Anspruch 1 oder 2, dadurch gekennzeichnet, dass am Eingabebereich (4) vorhandene Verschlussmittel, vorzugsweise eine Tür, mittels zwei separaten Betätigungsmitteln aktiviert, d.h. geschlossen werden, welche innerhalb einer bestimmten, einstellbaren Zeitspanne zusammen betätigt werden müssen.

4. Verfahren nach einem der Ansprüche 1 bis 3, dadurch gekennzeichnet, dass die Pods (5) kreisförmig angeordneten Lagerplätzen (8), welche vorzugsweise auf mehreren, übereinanderliegenden Ebenen angeordnet sind, zugeführt resp. weggeführt werden.

5. Vorrichtung zur Durchführung des Verfahrens nach einem der Ansprüche 1 bis 4 mit einem Ein- resp. Ausgabebereich (4), dadurch gekennzeichnet, dass sie mehrere, auf einer Kreisbahn angeordnete Lagerplätze (8) für Pods (5) aufweist, wobei mindestens ein Lagerplatz dem Ein- resp. Ausgabebereich als Austauschplatz (7;7') zugeordnet ist und Schwenkmittel (6) für die Zu- resp. Wegführung der Pods (5) aufweist, dass ferner eine um das Zentrum (11) der Kreisbahn verschwenkbare Transportvorrichtung (10) mit radial beweglichen Greifmitteln zum Erfassen der Pods (5) vorhanden ist, sowie eine linear verschiebbare Transfervorrichtung, welche auf mindestens einen Transferplatz (9;9') einwirkt, um darauf befindliche Pods (5) mit einer mit der Vorrichtung verbundenen Tranferstation (4) auszutauschen.

6. Vorrichtung nach Anspruch 5, dadurch gekennzeichnet, dass die Lagerplätze (8) auf mehreren, übereinanderliegenden Ebenen angeordnet sind.

7. Vorrichtung nach Anspruch 5 oder 6, dadurch gekennzeichnet, dass zwei nebeneinanderliegende Ein- resp. Ausgabebereiche (4',4'') vorhanden sind.

8. Vorrichtung nach einem der Ansprüche 5 bis 7, dadurch gekennzeichnet, dass zwei übereinanderliegende Transferplätze (9,9') angeordnet sind.

9. Vorrichtung nach einem der Ansprüche 5 bis 8, dadurch gekennzeichnet, dass die Pods (5) jeweils um denselben Winkel verschwenkt bezogen auf die radiale Achse (11) der Transportvorrichtung (10) auf den Lagerplätzen (8) gelagert werden, in welcher die Transfervorrichtung (10) linear bezüglich der Tangente vom Transferplatz (9;9') zum Zentrum (11) der Transportvorrichtung (10) bewegt wird.
